# EUROPEAN PATENT APPLICATION

(11) **EP 1 580 306 A2**
(43) Date of publication of application: **28.09.2005**
(21) Application number: 05251875.0
(22) Date of filing: 24.03.2005
(51) Int. Cl.: C30B 11/00, C30B 29/52

(54) **Single crystal investment cast components and methods of making same**

(30) Priority: 25.03.2004 US 809072
(71) Applicant: UNITED TECHNOLOGIES CORPORATION, Hartford, CT 06101 (US)
(72) Inventor: Bullied, Steven Joel, Pomfret Center, CT 06259 (US); Renaud, Robert Charles, Southbridge, MA 01550 (US); Marcin, John Joseph, Jr., Marlborough, CT 06447 (US); Garrison, Roy Alan, Chaplin, CT 06235 (US); Murray, Stephen Douglas, Marlborough, CT 06447 (US)
(74) Representative: Hall, Matthew Benjamin

(57) **Abstract**

High performance single crystal investment cast components and methods of making same are described herein. Embodiments comprise systems for producing such components. The systems comprise: an investment molding cavity; a seed crystal starter cavity; a seed crystal for initiating epitaxial crystal growth in molten metallic material that comes into contact therewith; a grain selector operatively connecting the seed crystal starter cavity and the investment molding cavity for at least one of: (1) selecting a single crystal from the seed crystal to grow into the molten metallic material during solidification, or (2) ensuring that a single crystal from the seed crystal continues to grow into the molten metallic material during solidification; and a grain selector support for at least partially supporting the weight of the investment molding cavity and any molten metallic material contained therein to take at least a portion of this weight off the grain selector, wherein the system is capable of producing a single crystal investment cast component. Methods for producing such components are also described.

## Description

The present invention relates generally to investment casting. More specifically, the present invention relates to utilizing seeds, grain selectors, and grain selector supports to produce high performance single crystal cast components, and methods of making same.

### BACKGROUND OF THE INVENTION

Investment casting has been used for many years to create near-net shape components that require minimal further machining after casting. Investment casting allows complex parts with intricate internal passages to be created. Generally, in the investment casting process, an injection molded wax pattern of a part is produced. The wax pattern may contain ceramic or refractory cores therein for creating the intricate internal passages in the finished component. Once formed, the wax pattern is encased in several layers of ceramic material to form a ceramic shell mold of the part. The wax is then removed from the ceramic shell mold via heating, and the ceramic shell mold is then fired and sintered in an oven. Thereafter, molten metal is poured into the ceramic shell mold, filling the cavities therein created by the evacuated or "lost" wax. The molten metal may then be selectively cooled to produce a final cast component having a desired controlled grain structure. Thereafter, the ceramic shell mold is removed, and the cast component can be heat treated, if desired, to strengthen the component and homogenize the metallurgical structure thereof.

Several known methods exist for obtaining controlled grain structures in cast parts, such as for example, directionally solidified casting and single crystal casting. In directionally solidified casting, a vacuum furnace comprising an active heating chamber and a lower-temperature chamber may be used. Prior to casting, and to help avoid nucleation other than at one predetermined end of the mold, the mold is generally heated in the active heating chamber to a temperature above the melting point of the molten metal that will be poured into the mold during casting. Next, molten metal is poured into the mold, and then the mold is gradually withdrawn from the active heating chamber and positioned within the lower-temperature chamber to control heat removal from the molten metal, which produces a predetermined directional solidification pattern in the cast component contained therein.

In its most technically sophisticated form, directional solidification comprises single crystal casting. In single crystal casting, a seed crystal may be used to initiate crystal growth when the molten metal is poured into the mold cavity, and to control crystal orientation as the solidification front progresses from the seed crystal into the molten metal in the mold cavity. When a single crystal seed crystal is used, a single crystal is expected to grow epitaxially upward from the seed crystal into the mold cavity. In this manner, the seed crystal determines the resulting unidirectional, single crystal of the final cast component. Alternatively or additionally to utilizing a seed crystal, a non-linear tubular grain selector may be utilized to ensure that a predetermined crystal structure is obtained in the final cast component. When used in combination with a seed crystal, this grain selector may be positioned between the seed crystal and the mold cavity to ensure that, even if bad crystal growth begins from the seed crystal (i.e., if no seed replication occurs therefrom) or if noisy crystal growth begins from the seed crystal (i.e., if marginal seed replication occurs therefrom), a high quality single crystal final cast component can still be obtained therefrom. Grain selector supports may also be utilized, if desired, to help bear some of the load placed on the grain selector during casting.

In current investment casting systems and methods, single crystal casting techniques are used, but often result in undesirable crystal structures in the final cast components if bad or noisy crystal growth starts occur. Additionally, poor production yields are often obtained due to bad or noisy crystal growth starts. Therefore, it would be desirable to have systems and methods that allow the optimum desired crystal structures to be achieved in the final cast components. Ideally, these systems and methods would allow optimum desired crystal structures to be achieved, even when bad and/or noisy crystal growth starts occur, thereby improving production yields.

Accordingly, the above-identified shortcomings of existing investment casting systems and methods are overcome by at least the preferred embodiments of the present invention, which relates to novel investment casting systems and methods that yield high performance single crystal investment cast components. These systems and methods utilize seed crystals, grain selectors, and grain selector supports to ensure that high quality, high performance single crystal cast components are obtained therefrom.

Embodiments of this invention comprise systems for producing high performance single crystal investment cast components. These systems may allow a production yield of at least 50% or greater to be achieved therefrom. These systems generally comprise: one or more investment molding cavities; a seed crystal starter cavity; a seed crystal for initiating epitaxial crystal growth in molten metallic material that comes into contact therewith; a grain selector operatively connecting the seed crystal starter cavity and the investment molding cavity for at least one of: (1) selecting a single crystal from the seed crystal to grow into the molten metallic material during solidification, or (2) ensuring that a single crystal from the seed crystal continues to grow into the molten metallic material during solidification; and a grain selector support for at least partially supporting the weight of the investment molding cavity and any molten metallic material contained therein to take at least a portion of this weight off the grain selector, wherein the system is capable of producing a single crystal investment cast component. Each seed crystal may be utilized to grow one or more single crystal investment cast components. The single crystal investment cast components may comprise gas turbine engine components.

In embodiments, these systems may comprise: a seed crystal; a grain selector in operable communication with the seed crystal; and a grain selector support capable of supporting at least a portion of weight bearing on the grain selector, wherein the system is capable of creating a single crystal investment cast component.

In embodiments, the seed crystals comprise a single crystal grain structure having a cross sectional shape of: a circle, a square, a rectangle, an oval, a semicircle, and/or a polygon, having a cross-sectional area of about 0.0007in² to about 0.625in². The seed crystals comprise a predetermined melting point such that the molten metallic material that comes into contact therewith melts back a portion of the seed crystal during casting. Additionally, the seed crystals comprise a height wherein the top of the seed crystal extends into the furnace far enough that the temperature at the top of the seed crystal exceeds a liquidus temperature of the seed crystal, while the temperature at the bottom of the seed crystal remains below a solidus temperature of the seed crystal. The seed crystals may comprise <001> primary and secondary crystallographic orientations, or they may comprise a <111> primary orientation and a <112> or a <110> secondary crystallographic orientation. The secondary orientation of the seed crystal may be aligned with a predetermined crystal plane, which is dictated by a casting feature where controlled secondary orientation is desired.

In embodiments, the seed crystals may comprise a nickel-based superalloy, an iron-based superalloy, a cobalt-based superalloy, and/or a refractory-based superalloy. The seed crystals may comprise at least one of the following alloying elements: cobalt (Co), chromium (Cr), carbon (C), iron (Fe), titanium (Ti), tantalum (Ta), aluminum (Al), molybdenum (Mo), tungsten (W), boron (B), niobium (Nb), zirconium (Zr), hafnium (Hf), yttrium (Y), rhodium (Rh), rhenium (Re), lanthanum (La), manganese (Mn), and silicon (Si), with the balance comprising nickel (Ni), iron (Fe), and/or cobalt (Co), and nominal impurities. The seed crystals may comprise about 5 wt. % chromium, about 10 wt. % cobalt, about 5.6 wt. % aluminum, about 1.9 wt. % molybdenum, about 5.9 wt. % tungsten, about 0.1 wt. % hafnium, about 8.7 wt. % tantalum, and about 3.0 wt. % rhenium, with the balance comprising nickel.

In embodiments, the grain selectors comprise a non-linear tubular structure connecting the seed crystal starter cavity to the investment molding cavity. The non-linear tubular structure may comprise a helix, a two-dimensional bend, a three-dimensional bend, a staircase, and/or a zigzag, having a cross-sectional shape of a circle, an oval, a triangle, a rectangle, a square, and/or a polygon. In embodiments, the non-linear tubular structure comprises a passageway therein having a cross-sectional area of about 0.00025in² to about 0.50in². In embodiments, the passageway may have a cross-sectional area no greater than about 1/9 the size of the surface area of the surface of the seed crystal to which the non-linear tubular structure is connected. The helix may comprise about 0.25 to about 10 turns per inch, and/or about 0.25 to about 10 turns total so that about 90° to about 3600° of rotation occurs from one end of the helix to the other. The helix may also comprise an inclination angle of about 50° +/- 30° from horizontal. The grain selector support may comprise a material capable of providing support to the grain selector up to temperatures of about 3100°F, such as a high strength ceramic, a glass, graphite, and/or a refractory metal. In embodiments, the grain selector may be positioned about the grain selector support, and comprise a rod with a cross-sectional shape of: a circle, a square, a rectangle, a triangle, and/or an oval, having a cross-sectional area of about 0.020in² to about 0.25in².

Embodiments of this invention also comprise methods for producing high performance single crystal investment cast components. These methods may comprise the steps of: disposing a seed crystal within a seed crystal starter cavity; providing a grain selector to operatively connect the seed crystal starter cavity to a mold cavity; utilizing a grain selector support to support the grain selector, the mold cavity, and any molten metal contained therein; introducing molten metal into the mold cavity; allowing the molten metal to flow from the mold cavity, through the grain selector, and into the seed crystal starter cavity; epitaxially nucleating and growing a single crystal from the seed crystal; and utilizing the grain selector in conjunction with the seed crystal to grow only a single crystal up into the molten metal in the mold cavity to yield the final high performance single crystal investment cast component.

Further features, aspects and advantages of the present invention will be readily apparent to those skilled in the art during the course of the following description, wherein references are made to the accompanying figures which illustrate some preferred forms of the present invention, and wherein like characters of reference designate like parts throughout the drawings.

Preferred embodiments of the present invention will now be described by way of example only and with reference to the accompanying drawings in which:
Figure 1 is a schematic diagram showing an exemplary investment casting system comprising a vacuum furnace, a seed crystal, a grain selector, and a grain selector support, as utilized in embodiments of this invention; and
Figure 2 is a schematic diagram showing the exemplary investment casting system of Figure 1, wherein the chill plate and mold are shown partially removed from the active heating chamber and positioned partially within the lower-temperature chamber.

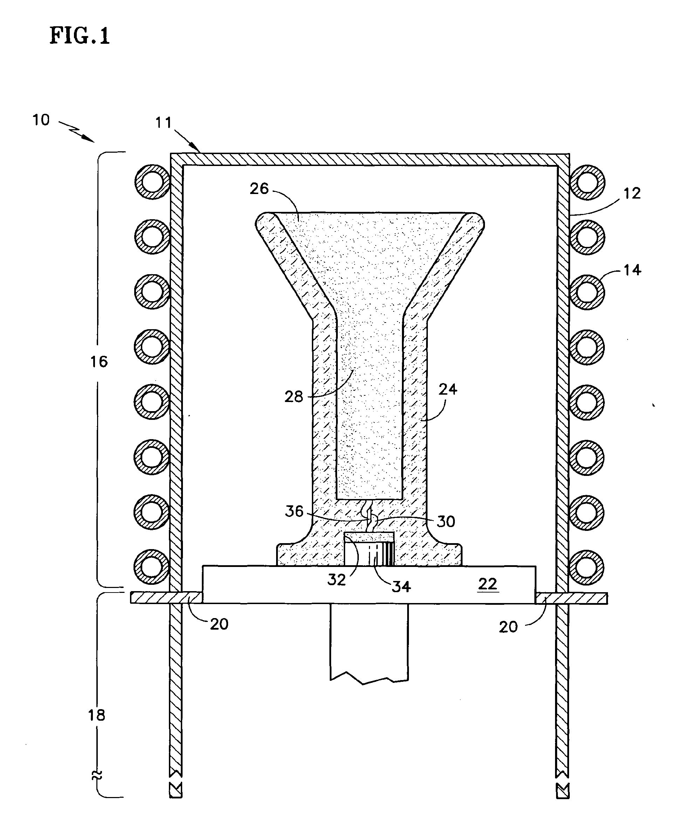

For the purposes of promoting an understanding of the invention, reference will now be made to some preferred embodiments of this invention as illustrated in FIGURES 1-2 and specific language used to describe the same. The terminology used herein is for the purpose of description, not limitation. Specific structural and functional details disclosed herein are not to be interpreted as limiting, but merely as a basis for the claims as a representative basis for teaching one skilled in the art to variously employ the present invention. Any modifications or variations in the depicted structures and methods, and such further applications of the principles of the invention as illustrated herein, as would normally occur to one skilled in the art, are considered to be within the spirit and scope of this invention.

This invention relates to systems and methods for creating high quality, high performance single crystal investment cast components. These systems and methods utilize seed crystals, grain selectors, and grain selector supports to improve the production yield of investment cast components, and to allow optimum desired crystal structures to be achieved in the final cast components, even when bad or noisy crystal growth starts occur initially.

As previously noted, investment casting can be used to create near-net shape components that require minimal further machining or processing after casting. Initially, an injection molded wax pattern of a part may be produced. This pattern may comprise ceramic or other refractory material cores within the wax that, when the wax is removed, will create intricate hollow passages within the final cast component. Such hollow castings are commonly used to produce complex parts such as gas turbine engine components. Once a wax pattern is formed, the pattern may then be encased in several layers of ceramic material (i.e., slurry and stucco) to form a ceramic shell mold of the part. Thereafter, the wax may be melted out and removed from the mold, and then the mold may be strengthened via sintering in an oven. Thereafter, in embodiments, a vacuum furnace may be used to create a single crystal cast component in this mold.

Single crystal cast components can be fabricated in numerous ways. If the desire is to control primary and secondary crystal growth in a single crystal cast component, or to grow a crystal in a direction that is not naturally preferred, a seed crystal can be used to preselect a primary and secondary orientation, and/or an unnatural orientation, for the final cast component. A seed crystal possessing known primary and secondary orientation can be fabricated in various manners, such as by machining a seed crystal from a previously-cast single crystal slab, or by casting one or more seed crystals from an existing seed crystal. The prefabricated seed crystal can then be affixed inside a seed crystal starter cavity within the investment casting ceramic shell mold. Typically, there is a gap between the top of the seed crystal and the top of the seed crystal starter cavity so that molten metal can pool in the gap and melt back a portion of the seed crystal during casting. The atoms within this molten metal pool then epitaxially copy the atomic structure of the seed crystal and continue to grow with controlled primary and secondary orientation into and throughout the single crystal cast component created therefrom.

If the desire is to control only the primary growth direction in a single crystal cast component, a grain selector can be used to select one dominant crystal from a single crystal seed crystal possessing many secondary columnar grains therein, thereby allowing the dominant crystal to continue growing into the final cast component while aligning all the atoms therein in a preferred primary orientation. The seed crystal can comprise any suitable geometric form that provides ample columnar grains from which the grain selector can choose a dominant crystal. Likewise, the grain selector can comprise any suitable geometric form that provides an obstruction to the non-preferred secondary crystals in the seed crystal so that only a single dominant crystal from the seed crystal is selected for continued growth into the final cast component. Grain selectors in the form of staircases, helices, and/or bends are commonly used to restrict grain growth.

Referring now to Figure 1, there is shown an exemplary investment casting system 10, as utilized in embodiments of this invention. In this particular system, a vacuum furnace 11 comprises a susceptor 12 that is heated by induction coils or electrical resistance heaters 14 located proximately thereto. This furnace 11 also comprises an active heating chamber 16, a lower-temperature chamber 18, a baffle 20 that serves as a radiation shield separating the two chambers, and a chill plate 22 that cools the base of the ceramic shell mold 24 that sits thereon. Prior to casting, and to help avoid nucleation other than at the bottom of the ceramic shell mold 24, the ceramic shell mold 24 may be heated in the active heating chamber 16 to a temperature above the melting point of the molten metal that will be poured into the ceramic shell mold 24 during casting.

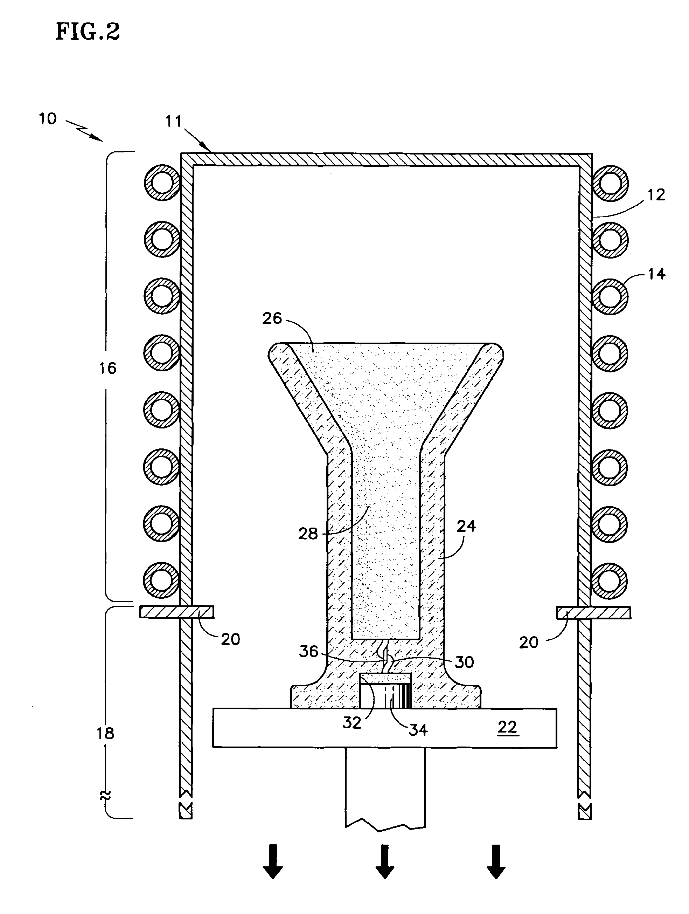

During casting, a predetermined alloy is melted and introduced into a refractory ceramic shell mold 24 via a pour cup 26. Some exemplary non-limiting alloys comprise cubic crystal structure nickel-based, iron-based, cobalt-based, and/or refractory-based superalloys. From the pour cup 26, the molten metal flows downwardly into the mold cavity 28, the grain selector 30, and the seed crystal starter cavity 32, wherein the molten metal melts a portion of the upper part of the seed crystal 34 disposed therein. The molten metal fills the cavities in the mold 24 created by the evacuated or "lost" wax, and encapsulates any ceramic/refractory cores positioned within the mold 24. The seed crystal 34 may sit directly on the chill plate 22, or it may be disposed within the mold 24 so as to be out of direct contact with the chill plate 22. The chill plate 22 cools the seed crystal 34 and the seed crystal starter cavity 32, thereby initiating solidification of the molten metal contained therein. Subsequent crystallization of the molten metal occurs by slowly lowering the chill plate 22 to gradually withdraw the ceramic shell mold 24 from the active heating chamber 16 and position it within the lower-temperature chamber 18 to establish and/or control unidirectional heat removal from the molten metal contained within the mold 24. As this occurs, a solidification front is first established in the molten metal portion of the seed crystal 34 in seed crystal starter cavity 32. Figure 2 shows the chill plate 22 and ceramic shell mold 24 partially removed from the active heating chamber 16 as it is being lowered into the lower-temperature chamber 18 during solidification. As the ceramic shell mold 24 is withdrawn from the active heating chamber 16, the solidification front moves upwardly through the molten metal in the grain selector 30 and into the molten metal in the mold cavity 28 to form a single crystal cast component therein. This produces a final cast component having a controlled grain structure with a predetermined directional solidification (i.e., single crystal) pattern therein. After casting, the ceramic shell mold 24 may be removed from the outside of the cast component (i.e., mechanically), and any refractory cores in the cast component may be removed therefrom via a mechanical or chemical dissolution process.

Generally, it has been believed that the use of grain selectors 30 is not necessary, and is often not even desired, when seed crystals 34 are used. However, it has been found that utilizing grain selectors 30 in addition to seed crystals 34 helps improve production yields and promote the formation of the optimum desired crystal structures in the final cast components, especially in the presence of bad or noisy crystal growth starts. For example, if a bad seed start occurs (i.e., if no seed replication occurs in the seed crystal starter cavity 32), the grain selector 30 can select one of the multiple columnar grains that has begun growing from the seed crystal, and propagate a single crystal into the molten metal in the mold cavity 28, saving an otherwise potentially bad casting. If marginal crystal growth begins in the seed crystal starter cavity 32, the grain selector 30 can select the major grain (i.e., the grain of the seed crystal 34) for propagation into the molten metal in the mold cavity 28, saving an otherwise potentially bad or marginal quality casting. If a clean start occurs (i.e., if 100% seed replication occurs and there are no grain defects in the seed crystal starter cavity 32), it has been shown that the grain selector 30 does not adversely affect the final cast component created therefrom. Furthermore, if a cast component is to be positioned in a casting mold in an orientation that minimizes post cast machining, but that orientation is not thermodynamically preferred for crystal growth, both a seed crystal and a grain selector may need to be utilized to ensure optimum primary and secondary crystal growth in the final cast component. Therefore, embodiments of this invention comprise utilizing a grain selector 30 in conjunction with a seed crystal 34. The seed crystal 34 and the grain selector 30 should both be designed to have the structural integrity necessary to minimize flexure and avoid craze cracks while the ceramic shell mold is being formed, thereby preventing metal finning during casting, which can disrupt normal crystal growth and cause stray crystals and non-preferred crystal orientations to form in the final cast component.

The seed crystals 34 utilized in this invention typically comprise cast cylindrical shapes, but any suitable shape or configuration may be used. For example, in embodiments, the seed crystal 34 may comprise a cylindrical shape having a round cross-section, a square cross-section, a rectangular cross-section, an oval cross-section, a semicircular cross-section, a polygonal cross-section, etc. Many other suitable shapes and/or configurations also exist. The seed crystal 34 may also be tapered so that one end of the seed (i.e., the bottom end) is larger than the other end of the seed (i.e., the top end). The seed crystal 34 may comprise any suitable cross-sectional area, and in embodiments, may be between about 0.0007in² and about 0.625in². The seed height is preferably of a dimension great enough that the top of the seed crystal extends into the furnace far enough that the temperature of the top of the seed crystal exceeds the liquidus temperature of the seed crystal, while the temperature of the bottom of the seed crystal is below the solidus temperature of the seed crystal.

The seed crystals 34 comprise a predetermined crystal structure (i.e., single crystal) and orientation that is desired in the final cast component. During casting, the crystal structure of the seed crystal 34 will be imparted to the final cast component via epitaxial crystal growth. The seed crystal 34 may be cast to have the desired crystallographic orientation, or the seed crystal 34 may be physically oriented with respect to the mold cavity 28 so as to impart the desired crystallographic orientation thereto. For example, in embodiments, the seed crystal 34 may be cast to have <001> primary and secondary crystallographic orientations, or <111> primary and <112> or <110> secondary crystallographic orientations. Also for example, in embodiments, the secondary crystallographic orientation may be aligned with a preferred crystal plane dictated by the casting feature where controlled secondary orientation is desired.

In embodiments, the seed crystal 34 may comprise one or more of the following materials: nickel-based, iron-based, cobalt-based, and/or refractory-based superalloys. In embodiments, the seed crystal 34 may comprise one or more of the following alloying elements: cobalt (Co), chromium (Cr), carbon (C), iron (Fe), titanium (Ti), tantalum (Ta), aluminum (Al), molybdenum (Mo), tungsten (W), boron (B), columbium/niobium (Cb/Nb), zirconium (Zr), hafnium (Hf), yttrium (Y), rhodium (Rh), rhenium (Re), lanthanum (La), manganese (Mn), and silicon (Si), with the balance comprising nickel (Ni), iron (Fe), and/or cobalt (Co), and nominal impurities. The seed crystals utilized in one embodiment of this invention may comprise PWA1484, which has the following composition (by weight percent): 5% chromium, 10% cobalt, 5.6% aluminum, 1.9% molybdenum, 5.9% tungsten, 0.1% hafnium, 8.7% tantalum, 3.0% rhenium, with the balance comprising nickel. In embodiments, the seed crystal composition has a melting point similar to or higher than that of the component alloy, so that the superheated metal of the component alloy melts back a small region of the top of the seed crystal during casting, without completely melting the entire seed crystal, to ensure that epitaxial growth occurs therefrom. One seed crystal can be used to grow an individual single crystal cast component, or to grow multiple single crystal cast components where each component comprises a controlled primary and secondary orientation.

In embodiments of this invention, one end of a grain selector 30 is operatively connected to and positioned above the seed crystal starter cavity 32. This grain selector 30 may be of any suitable shape/configuration to serve its intended purpose of ensuring continued single crystal growth in the molten metal in the mold cavity 28, or of converting columnar grain growth in the seed crystal 34 into single crystal growth in the molten metal in the mold cavity 28. The grain selector 30 may comprise any suitable non-linear tubular structure that comprises enough changes in direction to exclude all but the single crystal that is desired to continue growing into the final cast component. In various embodiments, a helix, a two- or three-dimensional bend, a staircase, a zigzag, or other suitable non-linear tubular structure may be utilized. In some embodiments, a helix may be preferred because corners and sharp turns tend to promote extraneous nucleation. The non-linear tubular structure may comprise any suitable cross-sectional shape, such as for example, a circle, an oval, a triangle, a rectangle, a square, a polygon, etc. The non-linear tubular structure is generally quite small and fragile, but it should have a passageway therein large enough to allow the molten metal to flow relatively freely therethrough. In embodiments, the passageway may have a cross-sectional area of about 0.00025in² to about 0.50in². In embodiments, the cross-sectional area of the passage diameter is no greater than about 1/9 the size of the surface area of the surface of the seed crystal 34 to which it is attached. In embodiments, if a helix is utilized, the helix may comprise about 0.25-10 turns per inch, and/or about 0.25-10 turns total so that about 90-3600° of rotation occurs from one end of the helix to the other. Additionally, the inclination angle of the helix may be about 50° +/- 30° from horizontal. Numerous other embodiments are also possible.

The other end of the grain selector 30 is operatively connected to and positioned below the mold cavity 28. When the mold cavity 28 is filled with molten metal, the relatively fragile grain selector 30 generally bears this weight, which can be quite significant. Often times, the weight may be too great for the grain selector 30 to support by itself, and the grain selector 30 may fracture or collapse on itself. Therefore, a grain selector support 36 may be used to help support the weight of the mold 24 and molten metal therein, thereby taking some of the load off the grain selector 30 itself. The grain selector support 36 may comprise any suitable material that can support the load imposed thereon, and that can also maintain its shape and strength at the high temperatures reached prior to and during casting (i.e., up to about 2600-3100°F). Some suitable non-limiting materials comprise high strength ceramic materials such as alumina, silica, alumina-silicate, zirconia, etc., and/or other materials such as glass, graphite, refractory metal, or the like. While the grain selector support 36 shown herein is a preformed ceramic rod having a circular cross-section, any suitable rod geometry may be used. For example, the grain selector support 36 may comprise a rod having a square cross-section, a rectangular cross-section, a triangular cross-section, an oval cross-section, etc. The grain selector support 36 may be of any suitable size to perform its intended purpose. For example, in embodiments, the grain selector support 36 may comprise a rod having a cross-sectional area of about 0.020-0.25in². Many other embodiments of the grain selector support are also possible.

This invention also comprises methods for producing high performance single crystal investment cast components. In embodiments, these methods may comprise these steps in the following non-limiting order: disposing a seed crystal within a seed crystal starter cavity; providing a grain selector to operatively connect the seed crystal starter cavity to a mold cavity; utilizing a grain selector support to support the grain selector, the mold cavity, and the molten metal contained therein; introducing molten metal into the mold cavity; allowing the molten metal to flow from the mold cavity, through the grain selector, and into the seed crystal starter cavity; epitaxially nucleating and growing a single crystal from the seed crystal; and utilizing the grain selector in conjunction with the seed crystal to grow only a single crystal up into the molten metal in the mold cavity to yield a final high performance single crystal investment cast component.

As described above, this invention provides systems and methods for creating high quality, high performance single crystal investment cast components. Advantageously, these systems and methods allow optimum desired crystal structures to be achieved in the final cast components, even when bad or noisy crystal growth starts occur initially. Therefore, casting defects due to grain misorientation are significantly reduced by the systems and methods of this invention, and production yields are thereby increased. Many other embodiments and advantages will be apparent to those skilled in the relevant art.

Various embodiments of this invention have been described in fulfillment of the various needs that the invention meets. It should be recognized that these embodiments are merely illustrative of the principles of various embodiments of the present invention. Numerous modifications and adaptations thereof will be apparent to those skilled in the art without departing from the spirit and scope of the present invention. Thus, it is intended that the present invention cover all suitable modifications and variations as come within the scope of the appended claims and their equivalents.

## Claims

1. A system comprising:
an investment molding cavity;
a seed crystal starter cavity;
a seed crystal for initiating epitaxial crystal growth in molten metallic material that comes into contact therewith;
a grain selector operatively connecting the seed crystal starter cavity and the investment molding cavity for at least one of: (1) selecting a single crystal from the seed crystal to grow into the molten metallic material during solidification, or (2) ensuring that a single crystal from the seed crystal continues to grow into the molten metallic material during solidification; and
a grain selector support for at least partially supporting the weight of the investment molding cavity and any molten metallic material contained therein to take at - least a portion of this weight off the grain selector,
wherein the system is capable of producing a single crystal investment cast component.

2. The system of claim 1, wherein the seed crystal comprises a single crystal grain structure.

3. The system of claim 1 or 2, wherein the seed crystal comprises a cross section of at least one of the following shapes: circle, square, rectangle, oval, semicircle, and polygon.

4. The system of claim 1, 2 or 3, wherein the seed crystal comprises a cross-sectional area of about 0.0007in² to about 0.625in².

5. The system of any preceding claim, wherein the seed crystal comprises a height wherein the top of the seed crystal extends into the furnace far enough that a temperature of the top of the seed crystal exceeds a liquidus temperature of the seed crystal, while a temperature of the bottom of the seed crystal remains below a solidus temperature of the seed crystal.

6. The system of any preceding claim, wherein the seed crystal comprises <001> primary and secondary crystallographic orientations.

7. The system of any of claims 1 to 5, wherein the seed crystal comprises a <111> primary orientation and a <112> or a <110> secondary crystallographic orientation.

8. The system of any preceding claim, wherein a secondary orientation of the seed crystal is aligned with a predetermined crystal plane dictated by a casting feature where - controlled secondary orientation is desired.

9. The system of any preceding claim, wherein the seed crystal comprises at least one of the following: a nickel-based superalloy, an iron-based superalloy, a cobalt-based superalloy, and a refractory-based superalloy.

10. The system of any of claims 1 to 8, wherein the seed crystal comprises at least one of the following alloying elements: cobalt (Co), chromium (Cr), carbon (C), iron (Fe), titanium (Ti), tantalum (Ta), aluminum (Al), molybdenum (Mo), tungsten (W), boron (B), niobium (Nb), zirconium (Zr), hafnium (Hf), yttrium (Y), rhodium (Rh), rhenium (Re), lanthanum (La), manganese (Mn), and silicon (Si), with the balance comprising nominal impurities and at least one of: nickel (Ni), iron (Fe), and cobalt (Co).

11. The system of any preceding claim, wherein the seed crystal comprises about 5 wt. % chromium, about 10 wt. % cobalt, about 5.6 wt. % aluminum, about 1.9 wt. % molybdenum, about 5.9 wt. % tungsten, about 0.1 wt. % hafnium, about 8.7 wt. % tantalum, and about 3.0 wt. % rhenium, with the balance comprising nickel.

12. The system of any preceding claim, wherein the seed crystal comprises a predetermined melting point such that the molten metallic material that comes into contact therewith melts back a portion of the seed crystal during casting.

13. The system of any preceding claim, further comprising at least two investment molding cavities.

14. The system of claim 13, wherein the seed crystal is utilized to grow at least two single crystal investment cast components.

15. The system of any preceding claim, wherein the grain selector comprises a non-linear tubular structure connecting the seed crystal starter cavity to the investment molding cavity.

16. The system of claim 15, wherein the non-linear tubular structure comprises at least one of: a helix, a two-dimensional bend, a three-dimensional bend, a staircase, and a zigzag.

17. The system of claim 15 or 16, wherein the non-linear tubular structure comprises at least one of the following cross-sectional shapes: a circle, an oval, a triangle, a rectangle, a square, and a polygon.

18. The system of claim 15, 16 or 17, wherein the non-linear tubular structure comprises a passageway therein having a cross-sectional area of about 0.00025in² to about 0.50in².

19. The system of any of claims 15 to 18, wherein the non-linear tubular structure comprises a passageway therein having a cross-sectional area no greater than about 1/9 a size of a surface area of a surface of the seed crystal to which the non-linear tubular structure is connected.

20. The system of claim 16, wherein the helix comprises about 0.25 to about 10 turns per inch.

21. The system of claim 16, wherein the helix comprises about 0.25 to about 10 turns total so that about 90° to about 3600° of rotation occurs from one end of the helix to the other.

22. The system of claim 16, wherein an inclination angle of the helix is about 50° +/- 30° from horizontal.

23. The system of any preceding claim, wherein the grain selector support comprises a material capable of providing support to the grain selector up to temperatures of about 3100°F.

24. The system of claim 23, wherein the material comprises at least one of: a high strength ceramic, a glass, graphite, and a refractory metal.

25. The systems of any preceding claim, wherein the grain selector is positioned about the grain selector support.

26. The system of any preceding claim, wherein the grain selector support comprises a rod with at least one of the following cross-sectional shapes: circular, square, rectangular, triangular, and oval.

27. The system of any preceding claim, wherein the grain selector support comprises a cross-sectional area of about 0.020in² to about 0.25in².

28. The system of any preceding claim, wherein the single crystal investment cast component comprises a gas turbine engine component.

29. A system comprising:
a seed crystal;
a grain selector in operable communication with the seed crystal; and
a grain selector support capable of supporting at least a portion of weight bearing on the grain selector,
wherein the system is capable of creating a single crystal investment cast component,

30. A method for producing a high performance single crystal investment cast component, the method comprising the steps of:
disposing a seed crystal within a seed crystal starter cavity;
providing a grain selector to operatively connect the seed crystal starter cavity to a mold cavity;
utilizing a grain selector support to support the grain selector, the mold cavity, and any molten metal contained therein;
introducing molten metal into the mold cavity;
allowing the molten metal to flow from the mold cavity, through the grain selector, and into the seed crystal starter cavity;
epitaxially nucleating and growing a single crystal from the seed crystal; and
utilizing the grain selector in conjunction with the seed crystal to grow only a single crystal up into the molten metal in the mold cavity to yield the high performance single crystal investment cast component.

31. The method of claim 30, wherein a single seed crystal starter cavity is operatively connected to a plurality of mold cavities.

32. The method of claim 30 or 31, wherein the seed crystal is utilized to grow at least two single crystal investment cast components.

33. The method of claim 30, 31 or 32, wherein the high performance single crystal investment cast component comprises a gas turbine engine component.

34. The method of any of claims 30 to 33, wherein the grain selector is positioned about the grain selector support.

35. The method of any of claims 30 to 34, wherein the grain selector support comprises a rod.
